# EUROPEAN PATENT SPECIFICATION

(11) **EP 3 716 315 B1**
(45) Date of publication and mention of the grant of the patent: **02.10.2024**
(21) Application number: 18880391.0
(22) Date of filing: 22.10.2018
(51) Int. Cl.: H01L 21/66, C30B 13/00, C30B 29/06, C30B 33/04

(54) **METHOD OF SELECTING SILICON SINGLE CRYSTALLINE SUBSTRATE**
VERFAHREN ZUR AUSWAHL EINES SILIZIUMEINKRISTALLSUBSTRATS
PROCÉDÉ DE SÉLECTION D'UN SUBSTRAT MONOCRISTALLIN DE SILICIUM

(30) Priority: 22.11.2017 JP 2017224867
(43) Date of publication of application: 30.09.2020
(73) Proprietor: Shin-Etsu Handotai Co., Ltd., Tokyo 100-0004 (JP)
(72) Inventor: TAKENO, Hiroshi, Annaka-shi Gunma 379-0196 (JP)
(74) Representative: Wibbelmann, Jobst
(86) International application number: PCT/JP2018/039134
(87) International publication number: WO 2019/102759

(56) References cited:
- WO-A1-2017/188323
- JP-A- 2012 199 299
- JP-A- 2012 199 299
- JP-A- 2016 127 192
- JP-A- 2016 127 192
- JP-A- H 077 060
- JP-A- H04 225 150
- JP-A- H11 340 479
- US-A1- 2013 169 283
- US-A1- 2016 282 284
- LAUER K ET AL: "Detailed analysis of the microwave-detected photoconductance decay in crystalline silicon", JOURNAL OF APPLIED PHYSICS, AMERICAN INSTITUTE OF PHYSICS, US, vol. 104, no. 10, 19 November 2008 (2008-11-19), pages 104503 - 104503, XP012116556, ISSN: 0021-8979, DOI: 10.1063/1.3021459

## Description

### TECHNICAL FIELD

The present invention relates to: a method for selecting a silicon single crystal substrate for controlling carrier recombination lifetime.

### BACKGROUND ART

In recent years, improvement of energy efficiency and reduction of greenhouse gases have been strongly required, and demand for an inverter which is a power semiconductor device has been growing. In order to increase the efficiency and reduce the size of an inverter device, a rise in the frequency of semiconductor devices is desired, and for this purpose, it is necessary to suppress power loss in semiconductor devices.

Main semiconductor devices that configure an inverter include IGBT (Insulated Gate Bipolar Transistor) and FWD (Free Wheeling Diode).

In an IGBT, when turning off from an on-state to an off-state in a switching operation, a tail current, which flows until carriers accumulated in a drift layer recombine and disappear, is generated. Therefore, with rise in frequency, there is a problem that power loss when turning off (turn-off loss) is increased.

In the case of an FWD, when a flowing current is cut off, a large amount of carriers present inside flow in the opposite direction, and after the reverse current increases to a maximum value, the reverse current starts to decrease, and this causes a period of time during which a tail current flows. When the tail current is large, there is a problem that power loss on reverse recovery (reverse recovery loss) increases.

As described, lowering the tail current on turning off the IGBT and the tail current on reverse recovery of the FWD to lower the overall power loss is important for raising the frequency and improving the efficiency of an inverter.

There are methods of forming an area with a short carrier recombination lifetime by irradiating with a particle beam or the like in order to lower the turn-off loss of the IGBT and reverse recovery loss of the FWD (Patent Document 1, Patent Document 2, and Patent Document 3). In these methods, by shortening the carrier recombination lifetime of a certain area, the tail current on turning off the IGBT and the tail current on reverse recovery of the FWD can be lowered effectively, and as a result, the overall power loss can be lowered.

Moreover, since formation of an oxygen donor in a silicon substrate which causes a slight variation in resistivity of the silicon substrate becomes a problem in breakdown voltage characteristics of power devices, an FZ (Floating Zone) silicon single crystal substrate which hardly contains oxygen or a silicon single crystal substrate having oxygen concentration extremely lowered by an MCZ method provided by adding application of a magnetic field to a CZ method are often used in high-performance devices.

As a method for measuring carrier recombination lifetime, a microwave photoconductive decay method (Microwave PhotoConductive Decay method: µ-PCD method) is widely used. In this µ-PCD method, firstly, a silicon single crystal substrate is irradiated with a light pulse having a greater energy than the bandgap of a silicon single crystal so that excess carriers are generated in the silicon single crystal substrate. Conductivity of a wafer increases due to the generated excess carriers, but subsequently, conductivity decreases with the passage of time because of excess carriers disappearing due to recombination. By detecting this change as change in reflective microwave power with time (excess carrier decay curve) and analyzing, recombination lifetime can be obtained. Note that when a silicon single crystal substrate is irradiated with a particle beam, a defect that forms a level which becomes a recombination center is generated in a forbidden band, and recombination lifetime is shortened.

Recombination lifetime is defined as the time it takes until excess carrier concentration decays to 1/e (=0.368) due to recombination (Non Patent Document 1). A time constant of the decay obtained from a decaying portion that can be regarded as an exponential function of the reflective microwave power (primary mode) is referred to as primary mode lifetime, and the time it takes until the reflective microwave power decays to 1/e of the reflective microwave power at the time of light pulse irradiation is referred to as 1/e lifetime. In the case of either definition for recombination lifetime, the recombination lifetime is obtained by analyzing a portion in the excess carrier decay curve having several ten percent, which is comparatively high, of an excess carrier concentration at the time of injection.

Patent document JP 2016 127192 A discloses a method for selecting a silicon single crystal substrate comprising substrate preparation, particle beam irradiation, a measurement using the microwave photoconductive decay method, and finally selecting a substrate, but is silent on the selection criterion according to the present invention.

Patent document US 2016/282284 A1 discloses carrier recombination lifetime and dividing a decay curve into a rapid decay part and a slow decay part, but does not refer to carrier recombination lifetime.

Patent document D3 JP H07 7060 A discloses a curve with a 1/ e and a 1/e 2 criterion, but does not refer to a microwave photoconductive decay method.

### CITATION LIST

### PATENT LITERATURE

Patent Document 1: Japanese Unexamined Patent Application Publication No. H10-074959
Patent Document 2: Japanese Unexamined Patent Application Publication No. 2014-056881
Patent Document 3: Japanese Unexamined Patent Application Publication No. H06-021358

### NON PATENT LITERATURE

Non Patent Document 1: JEIDA-53-1997 "Test Method for Recombination Lifetime in Silicon wafers by Measurement of Photoconductivity Decay by Microwave Reflectance"

### SUMMARY OF INVENTION

### TECHNICAL PROBLEM

As described above, in the manufacturing process of a power device, technology of suppressing tail current by using particle beam irradiation to control carrier recombination lifetime is used. However, there has been a problem that the characteristics of recombination lifetime which is concerned with the decay of excess carriers with a comparatively high concentration does not necessarily reflect the characteristics of a tail current in which the decay of excess carriers with a comparatively low concentration is concerned.

Generally, it is acknowledged that if recombination lifetime is short (that is, if the decay of excess carriers in high concentration is fast), tail current is suppressed (that is, the decay of excess carriers in low concentration also becomes fast). However, this is not necessarily the case, and there has been a problem that the decay of excess carriers in low concentration is sometimes slow even when recombination lifetime is short.

In addition, to further promote high speed and low power loss of switching devices, a silicon single crystal substrate in which a weaker tail current can be suppressed is desired. That is, a silicon single crystal substrate in which excess carriers in low concentration, which become the cause of a weak tail current, decay quickly is desired, but there has been no method for selecting such a silicon single crystal substrate, or it was not possible to select with high precision using the value of recombination lifetime.

The present invention has been made in view of the above problem, and an object thereof is to provide a method for selecting a silicon single crystal substrate in which the decay of excess carriers in low concentration become fast in order to suppress weak tail current in a power device for suppressing a tail current by controlling carrier recombination lifetime; and a silicon single crystal substrate selected by the method for selecting.

### SOLUTION TO PROBLEM

To achieve the object, the present invention provides a method for selecting a silicon single crystal substrate for controlling carrier recombination as set out in the appended claims 1-3.

By selecting a silicon single crystal substrate using such a method for selecting, a silicon single crystal substrate in which the decay of excess carriers in low concentration become fast in a power device for suppressing a tail current by controlling carrier recombination lifetime using particle beam irradiation can be selected. Thus, a weak tail current can be suppressed, and in this manner, power loss can be reduced.

In this event, in the particle beam irradiation step, an electron beam is preferably irradiated at an irradiation dosage of 3×10¹⁴/cm² or more and 9×10¹⁵/cm² or less.

By using an electron beam for irradiation at an irradiation dosage in such a range, difference in the decay of excess carriers in low concentration due to difference in silicon single crystal ingot can be made apparent, and a silicon single crystal substrate in which the decay of excess carriers in low concentration become fast can be selected with certainty.

In this event, in the measurement step, a microwave photoconductive decay method (µ-PCD method) is used.

In this manner, by using a µ-PCD method, the excess carrier decay curve can be measured extremely simply in a short time.

In this event, the tail portion of the excess carrier decay curve is a region in which the remaining excess carrier concentration is 10% or less of the excess carrier concentration at the time of injection.

In this manner, when the tail portion of the excess carrier decay curve is a region in which the remaining excess carrier concentration is 10% or less, difference in the decay of excess carriers in low concentration due to difference in silicon single crystal ingot can be made apparent, and a silicon single crystal substrate in which the decay of excess carriers in low concentration become fast can be selected with more certainty. Here, the lower limit of the remaining excess carrier concentration is not particularly limited, but, for example, when set to 0.5% or more, it is possible to prevent the carrier concentration becoming too low, making it impossible to measure with precision.

In this event, in the particle beam irradiation step, an electron beam is preferably irradiated at an irradiation dosage of 1×10¹⁵/cm², and in the judgement step, preferably, a decay time in which the remaining excess carrier concentration becomes 3% of the excess carrier concentration at the time of injection is obtained from the excess carrier decay curve, and when the obtained decay time is 2.0 psec or less, the silicon single crystal substrate is judged as acceptable.

By selecting under such judgement conditions, a silicon single crystal substrate in which the decay of excess carriers in low concentration become fast can be selected with more certainty.

Such a silicon single crystal substrate is a silicon single crystal substrate in which the decay of excess carriers in low concentration becomes fast in a power device for suppressing a tail current by controlling carrier recombination lifetime, and therefore, weak tail current can be suppressed, and in this manner, power loss can be reduced.

### ADVANTAGEOUS EFFECTS OF INVENTION

As described above, according to the inventive method for selecting a silicon single crystal substrate, it is possible to select a silicon single crystal substrate in which the decay of excess carriers in low concentration become fast when carrier recombination lifetime is controlled by particle beam irradiation. Therefore, a weak tail current can be suppressed in a power device for suppressing a tail current by controlling carrier recombination lifetime, and in this manner, power loss can be reduced. Furthermore, the inventive silicon single crystal substrate is a silicon single crystal substrate in which the decay of excess carriers in low concentration becomes fast in a power device for suppressing a tail current by controlling carrier recombination lifetime, and therefore, weak tail current can be suppressed, and in this manner, power loss can be reduced.

### BRIEF DESCRIPTION OF DRAWINGS

FIG. 1 is a diagram showing the flow of the inventive method for selecting a silicon single crystal substrate.
FIG. 2 is a diagram showing an example of an excess carrier decay curve measured in an experimental example.
FIG. 3 is a diagram showing the relation between the difference (J-C) in the decay time in the tail portions of the excess carrier decay curves of sample C and sample J measured in the experimental example and electron beam irradiation dosage.
FIG. 4 is a diagram showing the decay time in the tail portion of the excess carrier decay curve of each sample measured in the experimental example (electron beam irradiation dosage was 3×10¹⁵/cm², and the remaining excess carrier concentration at which the decay time was obtained was 1%).
FIG. 5 is a diagram showing the decay time in the tail portion of the excess carrier decay curve of each sample measured in the experimental example (electron beam irradiation dosage was 1×10¹⁵/cm², and the remaining excess carrier concentration at which the decay time was obtained was 3%).
FIG. 6 is a diagram showing the relation between the decay time in the tail portion of the excess carrier decay curve measured in the experimental example and carbon concentration.
FIG. 7 is a diagram showing the relation between the decay time in the tail portion of the excess carrier decay curve measured in the experimental example and phosphorous concentration.
FIG. 8 is a diagram showing the relation between the decay time in the tail portion of the excess carrier decay curve measured in the experimental example and 1/e lifetime.

### DESCRIPTION OF EMBODIMENTS

Hereinafter, the present invention will be described in detail with reference to the drawings as an example of an embodiment.

As described above, in the manufacturing process of a power device, technology of suppressing tail current by using particle beam irradiation to control carrier recombination lifetime is used. However, there has been a problem that the characteristics of recombination lifetime which is concerned with the decay of excess carriers with a comparatively high concentration does not necessarily reflect the characteristics of a tail current in which the decay of excess carriers with a comparatively low concentration is concerned. In addition, to further promote high speed and low loss of switching devices, a silicon single crystal substrate in which a weaker tail current can be suppressed is desired. That is, a silicon single crystal substrate in which excess carriers in low concentration, which become the cause of a weak tail current, decay quickly is desired, but there has been no method for selecting such a silicon single crystal substrate.

Accordingly, the present inventor has keenly studied and found out that, when an FZ silicon single crystal substrate is irradiated with a particle beam, then excess carriers are injected, and the decay of carrier concentration in relation to the subsequent passage of time is measured, difference due to difference in FZ silicon single crystal ingot in the tail portion having a lowered excess carrier concentration becomes large, and also found a silicon single crystal ingot in which the decay of excess carriers in low concentration become fast. Furthermore, the present inventor has found out that such a silicon single crystal substrate in which the decay of excess carriers in low concentration become fast is difficult to select with high precision from the value of recombination lifetime, and completed the present invention.

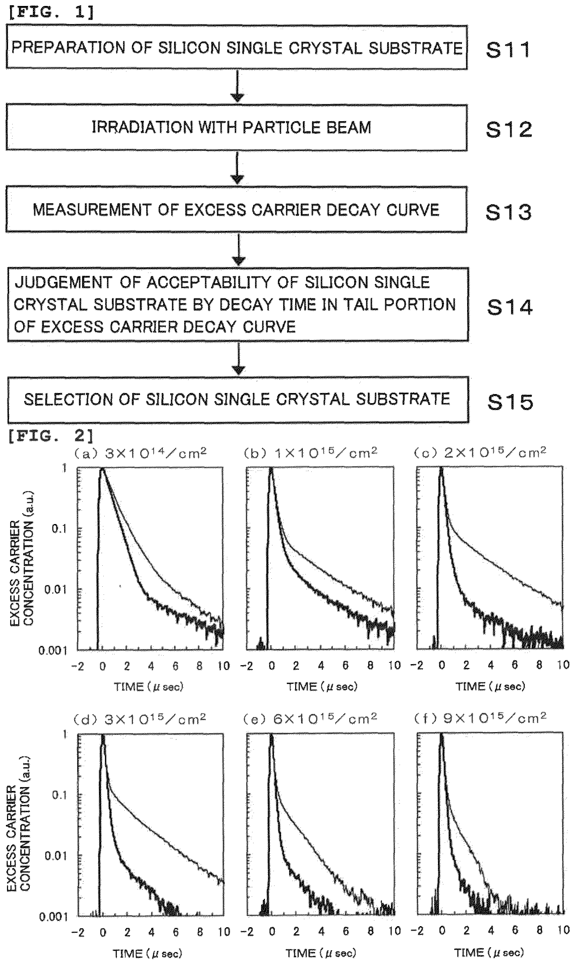

Hereinafter, the inventive method for selecting a silicon single crystal substrate will be described with reference to FIG. 1.

Firstly, a preparation step of preparing a silicon single crystal substrate as a candidate for a silicon single crystal substrate for controlling carrier recombination lifetime by fabrication from a silicon single crystal ingot grown by an FZ method is performed (S11 in FIG. 1). The specifications (diameter, resistivity, and the like) of the silicon single crystal substrate prepared here are not particularly limited, but are preferably made to meet requirements of the device.

In addition, the method for preparing this silicon single crystal substrate is not particularly limited in the present invention. For example, the silicon single crystal substrate can be prepared by slicing off a silicon wafer from a silicon single crystal ingot, performing a chemical etching treatment on the silicon wafer to eliminate slicing damage, and then performing chemical-mechanical polishing.

Next, a particle beam irradiation step of irradiating the silicon single crystal substrate with a particle beam is performed (S12 in FIG. 1). In this particle beam irradiation step, an electron beam can be irradiated as the particle beam at an irradiation dosage of 3×10¹⁴/cm² or more and 9×10¹⁵/cm² or less. Electron beam irradiation is widely used in the manufacturing process of power devices for controlling recombination lifetime, and therefore, the particle beam is preferably an electron beam.

By setting the irradiation dosage of the electron beam to 3×10¹⁹/cm² or more, difference in the decay of excess carriers in low concentration due to difference in silicon single crystal ingot can be made large, and a silicon single crystal substrate in which the decay of excess carriers in low concentration become fast can be selected with certainty.

In addition, by setting the irradiation dosage of the electron beam to 9×10¹⁵/cm² or less, difference in the decay of excess carriers in low concentration due to difference in silicon single crystal ingot can be made large, and a silicon single crystal substrate in which the decay of excess carriers in low concentration become fast can be selected with certainty, and loss of efficiency due to the irradiation taking too much time can be prevented. Acceleration voltage of the electron beam is not particularly limited, but may be an acceleration voltage used in the manufacturing process of power devices, and may be, for example, 0.5 to 2 MV.

Note that the type of particle beam for the irradiation is not limited to an electron beam. Charged particles such as protons, or helium ions can be selected and used as the particle beam.

Next, a measurement step of measuring an excess carrier decay curve of the silicon single crystal substrate after the particle beam irradiation step is performed (S13 in FIG. 1).

To measure the excess carrier decay curve, a microwave photoconductive decay method (µ-PCD method) is used. The measurement conditions in the µ-PCD method can be conditions generally used, for example, the measurement can be performed under conditions described in Non Patent Document 1 "JEIDA-53-1997 'Test Method for Recombination Lifetime in Silicon wafers by Measurement of Photoconductivity Decay by Microwave Reflectance'". In addition, as the measuring apparatus, a commercially available apparatus can be used.

Besides recombination centers generated in the silicon single crystal substrate, the excess carrier decay curve is also affected by surface recombination on the surface of the silicon single crystal substrate. When surface recombination of the silicon single crystal substrate becomes a problem in the measurement of the excess carrier decay curve, a treatment for suppressing surface recombination is performed. As this treatment for suppressing surface recombination, a thermal oxidation treatment (oxide film passivation) or an electrolytic solution treatment (chemical passivation) are generally used.

When oxide film passivation is used, an oxide film is preferably formed on the surface of the silicon single crystal substrate before the particle beam irradiation step. When oxide film passivation is performed before the particle beam irradiation step, surface recombination is suppressed, but there is no risk of recombination centers generated by particle beam irradiation disappearing. The oxide film can be formed by a heat treatment in an oxidizing atmosphere, for example. As conditions for the oxide film forming heat treatment, for example, a temperature can be set to 900°C or higher and 1100°C or lower, and a time can be set to 10 minutes or more and 60 minutes or less. When chemical passivation is used, in order to avoid the effect of change in passivation effect with the passage of time, the chemical passivation is preferably performed immediately before measuring the excess carrier decay curve.

Next, an judgement step of obtaining a decay time in which a remaining excess carrier concentration in a tail portion of the excess carrier decay curve measured above decays to a prescribed ratio of an excess carrier concentration at the time of injection and judging the silicon single crystal substrate as acceptable when a value of the decay time is a predetermined judgement value or less is performed (S14 in FIG. 1).

The judgement value can be determined by obtaining the relation between the device and the tail current characteristics thereof beforehand and setting the judgement value based on this relation so that the target tail current can be obtained. Moreover, it is desirable to determine the value so that, in a silicon single crystal ingot that can be manufactured by a current manufacturing technology, decay time in the tail portion becomes as short as possible within a range considering the balance between manufacturing cost and the effect of improving device characteristics.

In this event, the tail portion of the excess carrier decay curve can, as an example not forming part of the present invention, be set as a region in which the remaining excess carrier concentration is 15% or less of the excess carrier concentration at the time of injection, and 10% or less in the embodiments of the present invention. Moreover, the predetermined judgement value can be, for example, the time t1 (psec) required for the remaining excess carrier concentration to become X1(%) of the excess carrier concentration at the time of injection.

A silicon single crystal substrate that satisfies such an judgement value t1 (psec) or less is a silicon single crystal substrate in which the decay of excess carriers in low concentration become fast in a power device for controlling carrier recombination lifetime by particle beam irradiation, and is a silicon single crystal substrate for suppressing weak tail current.

The following can be considered as a reason why the difference in decay time due to difference in FZ silicon single crystal ingot is large in the tail portion of an excess carrier decay curve.

In the tail portion having a lowered excess carrier concentration of an excess carrier decay curve, decay of excess minority carriers (holes in the case of an N-conductive type silicon single crystal substrate) is dominant. When there is no external force working, the decay of excess carriers progresses by recombination of excess electrons and holes, and therefore, the decay of excess carriers is promoted by a rise in the concentration of defects that become carrier recombination centers. On the other hand, when defects that do not become carrier recombination centers but become carrier traps are present, recombination of carriers is suppressed by repeating capture and release of carriers, and the decay of excess carriers is sometimes suppressed. Accordingly, it can be conjectured that some factor of the FZ silicon single crystal ingot raises the concentration of defects that become minority carrier traps, suppressing the decay of excess minority carriers, thus making the difference due to difference in FZ silicon single crystal ingot large in the tail portion of the excess carrier decay curve.

Defects that affect the decay of excess carriers in high concentration are mainly carrier recombination centers, but defects that affect the decay of excess carriers in low concentration are both carrier recombination centers and minority carrier traps. Therefore, when minority carrier traps are not present, recombination lifetime reflects the decay time of excess carriers in low concentration, but when minority carrier traps are present, recombination lifetime does not reflect the decay time of excess carriers in low concentration.

The reality of minority carrier traps is not clear, but they are considered to be composites of point defects (atomic vacancies and interstitial silicons) generated by particle beam irradiation and light element impurities (dopant, carbon, oxygen, nitrogen, or the like) contained in a silicon single crystal. Therefore, a silicon single crystal substrate sliced off from the same silicon single crystal ingot having an almost uniform light element impurity concentration has almost the same decay characteristics of excess carriers in low concentration. However, since the concentration of minority carrier traps varies according to absolute concentration and concentration balance of the light element impurity, selection by the concentration of only one light element impurity is difficult.

Next a selection step is performed (S15 in FIG. 1). In this selection step, a silicon single crystal substrate fabricated from the same silicon single crystal ingot as the silicon single crystal ingot from which the silicon single crystal substrate judged as acceptable in the judgement step was fabricated is selected as the silicon single crystal substrate for controlling recombination lifetime.

When a silicon single crystal substrate is selected in this manner, a silicon single crystal substrate in which the decay of excess carriers in low concentration become fast in a power device for controlling carrier recombination lifetime using particle beam irradiation can be selected with certainty.

Fabrication of the silicon single crystal substrate from the same silicon single crystal ingot as the silicon single crystal ingot from which the silicon single crystal substrate judged as acceptable in the judgement step was fabricated may be performed after completing the steps shown in S11 to S15 in FIG. 1, but multiple silicon single crystal substrates can be fabricated at the same time when fabricating a candidate silicon single crystal substrate from the silicon single crystal ingot in S11.

A silicon single crystal substrate selected in this manner by the method for selecting a silicon single crystal substrate according to the present invention is a silicon single crystal substrate in which the decay of excess carriers in low concentration become fast in a power device for controlling carrier recombination lifetime by particle beam irradiation, and is therefore a silicon single crystal substrate that can suppress a weak tail current, and in this manner, power loss can be reduced. Accordingly, it is possible to select a silicon single crystal substrate suitable as a silicon single crystal substrate for a power device for controlling carrier recombination lifetime by particle beam irradiation.

Subsequently, the silicon single crystal substrate will be described.

The present inventor has succeeded in finding, a silicon single crystal substrate in which the decay of excess carriers in low concentration become fast in a silicon single crystal substrate after particle beam irradiation. Furthermore, the present inventor has found that a silicon single crystal substrate in which the decay of excess carriers in low concentration become fast is difficult to identify from the value of recombination lifetime

The silicon single crystal substrate is a silicon single crystal substrate for controlling carrier recombination lifetime, wherein after irradiating with an electron beam at an irradiation dosage of 1×10¹⁵/cm², excess carriers are injected, and when a decay curve of an excess carrier concentration (excess carrier decay curve) in relation to time elapsed after injecting the excess carriers is measured, in the excess carrier decay curve, a decay time in which a remaining excess carrier concentration becomes 3% of the excess carrier concentration at the time of injection is 2.0 psec or less.

Such a silicon single crystal substrate is a silicon single crystal substrate in which the decay of excess carriers in low concentration becomes fast in a power device for suppressing a tail current by controlling carrier recombination lifetime, and therefore, weak tail current can be suppressed, and in this manner, power loss can be reduced.

The silicon single crystal substrate is suitable as a silicon single crystal substrate for a power device for controlling carrier recombination lifetime by particle beam irradiation. As the particle beam in controlling recombination lifetime, protons or helium ions or the like are sometimes used besides an electron beam, but the silicon single crystal substrate becomes a silicon single crystal substrate in which the decay of excess carriers in low concentration become fast as described above in any instance of controlling using any particle beam irradiation.

The silicon single crystal ingot from which the silicon single crystal substrate is sliced off is grown by the FZ method, and specifications such as diameter and resistivity are not particularly limited, but are preferably made to meet requirements of the device.

In the present invention, a reason to use the above-described method for selecting a silicon single crystal substrate to suppress a weak tail current in a silicon single crystal substrate for controlling carrier recombination lifetime by particle beam irradiation is based on the knowledge obtained by an experiment described below.

### (Experimental Example)

Multiple silicon single crystal substrates sliced off from each of multiple silicon single crystal ingots manufactured by the FZ method were prepared. A dopant type, dopant concentration, oxygen concentration, carbon concentration, nitrogen concentration, a diameter, and a crystal plane orientation of each of the multiple silicon single crystal substrates are as described below.

The dopant type/concentration: phosphorous/6.2×10¹³ to 7.8×10¹³ atoms/cm³,
the oxygen concentration: less than 0.1 ppma, 0.2 to 0.4 ppma (JEIDA),
the carbon concentration: 0.01 to 0.10 ppma (JEIDA),
the nitrogen concentration: 3.6×10¹⁴ to 3.1×10¹⁵ atoms/cm³,
the diameter: 200 mm, 150 mm, and
the crystal plane orientation: (100).

The silicon single crystal substrates having an oxygen concentration of less than 0.1 ppma are manufactured from the silicon single crystal ingot grown by the FZ method using a normal polycrystalline silicon rod as a starting material (hereinafter, sometimes referred to as pure Poly-FZ substrates). Further, the silicon single crystal substrates having oxygen concentration of 0.2 to 0.4 ppma are manufactured from the silicon single crystal ingot grown by the FZ method using a silicon single crystal rod grown by the CZ method as a starting material (hereinafter, sometimes referred to as CZ-FZ substrates). Four levels of pure Poly-FZ substrates having a diameter of 200 mm (A to D), three levels of pure Poly-FZ substrates having a diameter of 150 mm (E to G), four levels of CZ-FZ substrates having a diameter of 200 mm (H to K), and three levels of CZ-FZ substrates having a diameter of 150 mm (L to N) were prepared.

Next, oxide film passivation was performed on the prepared multiple silicon single crystal substrates. In this event, the oxide film passivation was performed by forming an oxide film by an oxidation heat treatment. The heat treatment temperature was 1000°C, the duration was 60 minutes, and the atmosphere was oxygen.

Next, the multiple silicon single crystal substrates after the oxide film formation were irradiated with an electron beam. In this event, an irradiation dosage of the electron beam was 3×10¹⁴ to 9×10^{15/}cm², and an acceleration voltage of the electron beam was 2MV with any irradiation dosage.

Next, in each of the multiple silicon single crystal substrates irradiated with the electron beam, an excess carrier decay curve was measured by the µ-PCD method.

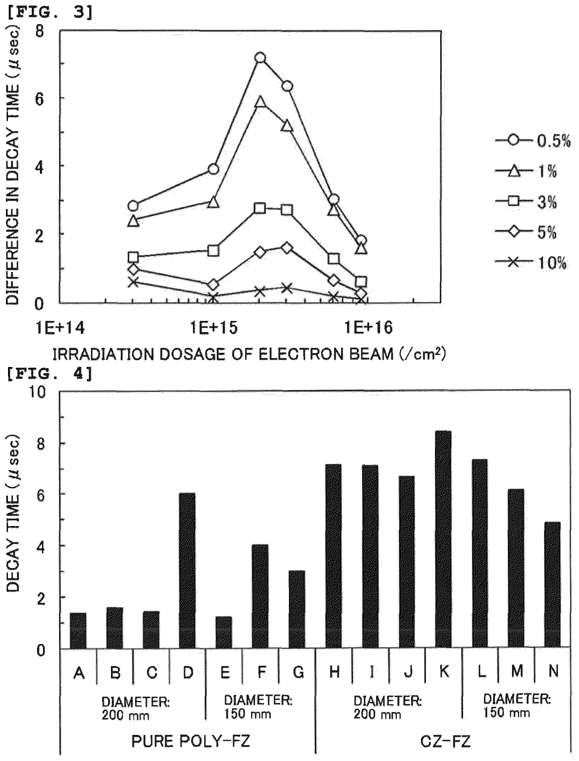

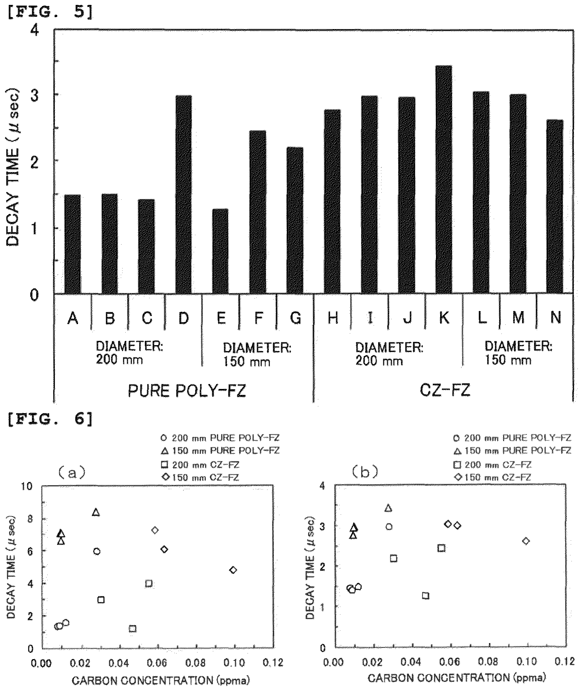

Examples of the measured excess carrier decay curve in sample C and sample J are shown in FIG. 2. Sample C is a pure Poly-FZ substrate having a diameter of 200 mm, an oxygen concentration of less than 0.1 ppma, a carbon concentration of 0.01 ppma, and a nitrogen concentration of 2.3×10¹⁵ atoms/cm³. Sample J is a CZ-FZ substrate having a diameter of 200 mm, an oxygen concentration of 0.2 ppma, a carbon concentration of 0.01 ppma, and a nitrogen concentration of 3.1×10¹⁵ atoms/cm³. The carrier concentration on the vertical axis of FIG. 2 is standardized with the peak concentration at the time of carrier injection set to 1. The irradiation dosage of the electron beam is 3×10¹⁴/cm² in FIG. 2 (a), 1×10¹⁵/cm² in FIG. 2 (b), 2×10¹⁵/cm² in FIG. 2 (c), 3×10¹⁵/cm² in FIG. 2 (d), 6×10¹⁵/cm² in FIG. 2 (e), and 9×10¹⁵/cm² in FIG. 2 (f) . In each graph, the thick line shows sample C, and the thin line shows sample J.

As described above, it can be observed that an excess carrier decay curve can be roughly divided into an early portion with a high decay rate and a latter portion with a low decay rate (tail portion) in the case of any irradiation dosage and in the case of any silicon single crystal substrate, and that behavior is different in a portion with a comparatively high excess carrier concentration from which recombination lifetime can be obtained and a tail portion with a comparatively low excess carrier concentration. Moreover, it can be observed that difference due to difference in silicon single crystal ingot is large in the tail portion. Furthermore, it can be observed that with every irradiation dosage, sample C has a shorter decay time in the tail portion than sample J.

Next, in the tail portion of the measured excess carrier decay curve, the decay time t1 (psec) required for the remaining excess carrier concentration to become X1(%) of the excess carrier concentration at the time of injection was obtained.

The relation between the difference (J-C) in the decay time of sample C and sample J and the electron beam irradiation dosage is shown in FIG. 3. The difference in the symbols in FIG. 3 indicates the difference in the remaining excess carrier concentration at which decay time was obtained, and "o" indicates a case at 0.5%, "Δ" at 1%, "□" at 3%, "0" at 5%, and "×" at 10%.

The difference (J-C) in the decay time of sample C and sample J is a positive value with any electron beam irradiation dosage and at any remaining excess carrier concentration, indicating that sample C has a shorter decay time in the tail portion than sample J. In particular, when the electron beam irradiation dosage is 2×10¹⁵ to 3×10¹⁵/cm², the difference in the decay time of sample C and sample J is large, indicating that the difference in decay time due to difference in FZ silicon single crystal ingot can be evaluated with high sensitivity.

Regarding samples A to N, examples of decay time in the tail portion of the excess carrier decay curves are classified by the starting material and diameter of the silicon single crystal ingot and shown in FIG. 4 and FIG. 5. FIG. 4 shows the cases where the electron beam irradiation dosage was 3×10¹⁵/cm², and the remaining excess carrier concentration at which decay time was obtained was 1%, and FIG. 5 shows the cases where the electron beam irradiation dosage was 1×10¹⁵/cm², and the remaining excess carrier concentration at which decay time was obtained was 3%.

As described above, it can be observed that a silicon single crystal substrate of which decay time in the tail portion of the excess carrier decay curve is short cannot be selected by difference in the starting material of the silicon single crystal ingot or diameter. Moreover, it is not always possible to select by the starting material of the silicon single crystal ingot, which indicates that it is not possible to select by the oxygen concentration of the silicon single crystal substrate.

In this event, for example, under the conditions of FIG. 4 or FIG. 5, by setting the judgement value of the decay time to 2 psec, a silicon single crystal substrate in which the decay of excess carriers in low concentration become fast can be selected, and therefore, a weak tail current can be controlled.

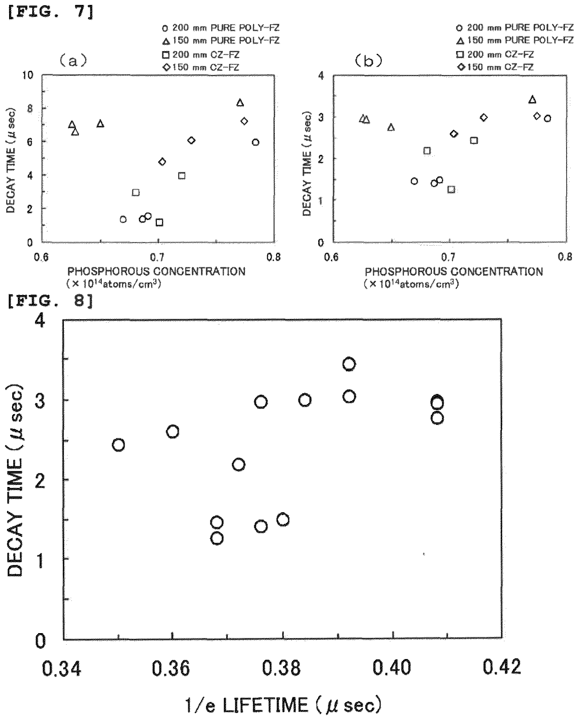

Next, the relation between the decay time in the tail portion of the excess carrier decay curve and the carbon concentration of the silicon single crystal substrate is shown in FIG. 6, and the relation with phosphorous concentration thereof is shown in FIG. 7. In each graph, the electron beam irradiation dosage and the remaining excess carrier concentration at which decay time was obtained are 3×10¹⁵/cm² and 1% in (a) and 1×10¹⁵/cm² and 3% in (b). The difference in the symbols in each graph indicates the difference in the diameter and the starting material of the silicon single crystal ingot, and "o" indicates pure Poly-FZ with a diameter of 200 mm, "Δ" indicates pure Poly-FZ with a diameter of 150 mm, "□" indicates CZ-FZ with a diameter of 200 mm, and "0" indicates CZ-FZ with a diameter of 150 mm.

From the results, it can be observed that a silicon single crystal substrate having a short decay time in the tail portion of the excess carrier decay curve cannot be selected by the concentration of carbon or phosphorous contained in the silicon single crystal substrate.

Next, the relation between the decay time in the tail portion of the excess carrier decay curve and 1/e lifetime is shown in FIG. 8. The electron beam irradiation dosage was 1×10¹⁵/cm², and the remaining excess carrier concentration at which the decay time was obtained was 3%.

From the results, it can be observed that a silicon single crystal substrate having a short decay time in the tail portion of the excess carrier decay curve cannot be selected by a recombination lifetime as generally defined.

A reason why a silicon single crystal substrate having a short decay time in the tail portion of the excess carrier decay curve cannot be selected only by the concentration of any of phosphorous, carbon, or oxygen contained in the silicon single crystal substrate as described above can be considered as follows.

When a silicon single crystal substrate is irradiated with a high-energy particle beam, a silicon atom at a lattice position is flicked out, and an interstitial silicon (hereinafter referred to as I) and a vacancy (hereinafter referred to as V) which is an empty shell thereof are produced. Since the excessively produced I or V is unstable when it is alone, they recombine (V+I→O), clustering of Is or clustering of Vs occurs, or they react with a light element impurity contained in the silicon single crystal substrate to form a composite. Additionally, the cluster of I or V or the composite of I or V and the light element impurity forms a deep level in a bandgap of silicon, functions as a recombination center of carriers, and decreases the recombination lifetime. Moreover, part of the composite works as minority carrier traps, and suppresses recombination of excess minority carriers.

It has been known that, as a defect concerning the vacancy V, V and a substitutional phosphorous Ps react to form VP (V+Ps→VP). Further, V and the interstitial oxygen Oi react to form VO (V+Oi→VO), and further, a V and VO react to form V₂O (V+VO→V₂O) in some cases. Furthermore, a pair of V react to form VV (V+V->VV) When nitrogen is present, V and N react to form VN (V+N→VN). Since reactions of V and P, O, or N compete against each other, if VN is apt to be formed when the nitrogen concentration is high, there is a possibility that other composites to which V relates are not easily formed.

On the other hand, it has been known that, as defects to which the interstitial silicon I relates, I and substitutional boron Bs react to form interstitial boron Bi (I+Bs→Bi), and further, Bi and Oi react to form BiOi (Bi+Oi→BiOi). Furthermore, when carbon is present, I and the substitutional carbon Cs react to form an interstitial carbon Ci (I+Cs→Ci), and further, Ci and Oi or Ci and Cs react to form CiOi or CiCs (Ci+Oi→CiOi, Ci+Cs→CiCs). Moreover, I also reacts with other I to form an I cluster (I+I+...→In). When nitrogen is present, a reaction of V and N suppresses the recombination of V and I, and hence there is a possibility that a composite to which I relates is apt to be formed.

Since the reaction of I or V and a light element impurity is dependent on each absolute concentration and a concentration balance, it is very complicated, and estimating which composite becomes dominant is difficult. Thus, it can be conjectured that the concentration of the composites that work as minority carrier traps does not depend only on the concentration of any of phosphorous, carbon, or oxygen contained in the silicon single crystal substrate.

Accordingly, as in the present invention, by irradiating a silicon single crystal substrate with an electron beam, then obtaining the decay time in the tail portion of the measured excess carrier decay curve, and selecting a silicon single crystal substrate such that the value is a predetermined judgement value or less, it is possible to select a silicon single crystal substrate in which the decay of excess carriers in low concentration become fast, and therefore, variation in tail current due to the silicon single crystal substrate can be made small, and in addition, a weak tail current can be suppressed.

### EXAMPLE

Hereinafter, the present invention will be described more specifically with reference to Examples.

### (Example)

In the Example, regarding silicon single crystal substrates fabricated from two types of FZ silicon single crystal ingot (ingots 1 and 2), acceptability of a silicon single crystal substrate fabricated from each silicon single crystal ingot was judged and selection was performed according to the inventive method for selecting.

### (Ingot 1)

Firstly, a silicon single crystal ingot having a phosphorous concentration of 7×10¹³ atoms/cm³ (ingot 1) was grown by the FZ method. The diameter was 200 mm, and the crystal axis orientation was <100>. The oxygen concentration was less than 0.1 ppma, and the carbon concentration was 0.01 ppma. Next, from the silicon single crystal ingot, a silicon single crystal substrate with a mirror-polish finish was fabricated by a standard wafer processing process.

Next, an oxide film was formed on the fabricated silicon single crystal substrate by an oxidation heat treatment (oxide film passivation). The oxidation heat treatment temperature was 1000°C, duration was 60 minutes, and the atmosphere was oxygen. Next, the silicon single crystal substrate with the oxide film formed was irradiated with an electron beam. The irradiation dosage of the electron beam was 1×10¹⁵/cm², and the acceleration voltage of the electron beam was 2MV.

Subsequently, an excess carrier decay curve of the silicon single crystal substrate irradiated with the electron beam was measured by a µ-PCD method. As a result, the decay time required for the remaining excess carrier concentration to become 3% was 1.5 psec, and since this was shorter than the judgement value of 2.0 µsec, which is the standard for judging acceptability, the silicon single crystal substrate was judged as acceptable for a silicon single crystal substrate for controlling recombination lifetime. By setting the judgement value to 2.0 µsec, it was possible to select a silicon single crystal substrate in which the decay of excess carriers in low concentration become as quickly as possible from the FZ silicon single crystal ingot.

Next, a silicon single crystal substrate fabricated from the same silicon single crystal ingot (ingot 1) as the silicon single crystal ingot from which the silicon single crystal substrate judged as acceptable was fabricated was selected as the silicon single crystal substrate for controlling recombination lifetime.

Next, a device was fabricated using the selected silicon single crystal substrate, and as a result of evaluating the tail current on turning off, it was confirmed that the tail current was low and suppressed.

### (Ingot 2)

Firstly, a silicon single crystal ingot having a phosphorous concentration of 8×10¹³ atoms/cm³ (ingot 2) was grown by the FZ method. The diameter was 200 mm, and the crystal axis orientation was <100>. The oxygen concentration was 0.2 ppma, and the carbon concentration was 0.03 ppma. Next, from the silicon single crystal ingot, a silicon single crystal substrate with a mirror-polish finish was fabricated by a standard wafer processing process.

Next, an oxide film was formed on the fabricated silicon single crystal substrate by an oxidation heat treatment (oxide film passivation). The oxidation heat treatment temperature was 1000°C, duration was 60 minutes, and the atmosphere was oxygen. Next, the silicon single crystal substrate with the oxide film formed was irradiated with an electron beam. The irradiation dosage of the electron beam was 1×10¹⁵/cm², and the acceleration voltage of the electron beam was 2MV.

Subsequently, an excess carrier decay curve of the silicon single crystal substrate irradiated with the electron beam was measured by a µ-PCD method. As a result, the time required for the excess carrier concentration to decay to 3% was 3.4 psec. Since this was longer than the judgement value of 2.0 psec, which is the standard for judging acceptability, the silicon single crystal substrate was judged as unacceptable for a silicon single crystal substrate for controlling recombination lifetime. It was then decided not to use a silicon single crystal substrate fabricated from the same silicon single crystal ingot (ingot 2) as the silicon single crystal ingot from which the silicon single crystal substrate judged as unacceptable was fabricated as the silicon single crystal substrate for controlling recombination lifetime.

As described above, it was confirmed that using the inventive method for selecting, a silicon single crystal substrate in which the decay of excess carriers in low concentration become slow is eliminated, variation in the decay time of excess carriers due to the silicon single crystal ingot itself becomes small, and a silicon single crystal substrate in which the decay of excess carriers in low concentration become fast can be selected with precision.

It should be noted that the present invention is not limited to the above-described embodiments, and only limited to the claims. The embodiments are just examples, and any examples that have substantially the same feature and demonstrate the same functions and effects as those in the technical concept disclosed in claims of the present invention are to be considered.

## Claims

1. A method for selecting a silicon single crystal substrate for controlling carrier recombination lifetime, comprising:
a preparation step (S11) of preparing a silicon single crystal substrate as a candidate for the silicon single crystal substrate by fabrication from a silicon single crystal ingot grown by a floating zone melting method, FZ method;
a particle beam irradiation step (S12) of irradiating the prepared silicon single crystal substrate with a particle beam;
a measurement step (S13) of injecting excess carriers into the silicon single crystal substrate after the particle beam irradiation step (S12) and measuring a decay curve of an excess carrier concentration, excess carrier decay curve, in relation to time elapsed after injecting the excess carriers, wherein a microwave photoconductive decay method is used as a method for measuring the decay curve;
a judgement step (S14) of obtaining, in the measured excess carrier decay curve, a decay time after which a remaining excess carrier concentration reaches a tail portion of the decay curve, wherein the tail portion is defined as the region in which the remaining excess carrier concentration is 10% or less of the excess carrier concentration at the time of injection and judging the silicon single crystal substrate as acceptable when a value of the decay time is a predetermined judgement value or less; and
a selection step (S15) of selecting a silicon single crystal substrate fabricated from the same silicon single crystal ingot as the silicon single crystal ingot from which the silicon single crystal substrate judged as acceptable in the judgement was fabricated as the silicon single crystal substrate for controlling carrier recombination lifetime.

2. The method for selecting a silicon single crystal substrate according to claim 1, wherein in the particle beam irradiation step (S12), an electron beam is irradiated at an irradiation dosage of 3×10¹⁴/cm² or more and 9×10¹⁵/cm² or less.

3. The method for selecting a silicon single crystal substrate according to claim 1 or 2, wherein in the particle beam irradiation step (S12), an electron beam is irradiated at an irradiation dosage of 1×10¹⁵/cm², and
in the judgement step (S14), a decay time in which the remaining excess carrier concentration becomes 3% of the excess carrier concentration at the time of injection is obtained from the excess carrier decay curve, and when the obtained decay time is 2.0 psec or less, the silicon single crystal substrate is judged as acceptable.

## Patentansprüche

1. Verfahren zum Auswählen eines Silizium-Einkristallsubstrats zum Steuern einer Ladungsträger-Rekombinationslebensdauer, umfassend:
einen Präparationsschritt (S11) des Präparierens eines Silizium-Einkristallsubstrats als Kandidat für das Silizium-Einkristallsubstrat durch Herstellung aus einem Silizium-Einkristallblock, der durch ein Floating-Zone-Melting-Verfahren, FZ-Verfahren, gezüchtet wurde;
einen Teilchenstrahl-Bestrahlungsschritt (S12) des Bestrahlens des präparierten Silizium-Einkristallsubstrats mit einem Teilchenstrahl;
einen Messschritt (S13) des Injizierens von überschüssigen Ladungsträgern in das Silizium-Einkristallsubstrat nach dem Teilchenstrahl-Bestrahlungsschritt (S12) und des Messens einer Abklingkurve einer überschüssigen Ladungsträgerkonzentration, Überschuss-Ladungsträger-Abklingkurve, in Abhängigkeit von der nach dem Injizieren der überschüssigen Ladungsträger verstrichenen Zeit, wobei ein Mikrowellen-Photoleitfähigkeits-Abklingverfahren als Verfahren zum Messen der Abklingkurve verwendet wird;
einen Beurteilungsschritt (S14), bei dem in der gemessenen Überschuss-Ladungsträger-Abklingkurve eine Abklingzeit ermittelt wird, nach der eine verbleibende Überschuss-Ladungsträgerkonzentration einen Endabschnitt der Abklingkurve erreicht,
wobei der Endabschnitt als der Bereich definiert ist, in dem die verbleibende überschüssige Ladungsträgerkonzentration 10% oder weniger der überschüssigen Ladungsträgerkonzentration zum Zeitpunkt der Injektion beträgt und das Silizium-Einkristallsubstrat als akzeptabel beurteilt wird, wenn ein Wert der Abklingzeit ein vorbestimmter Beurteilungswert oder weniger ist; und
einen Auswahlschritt (S15) des Auswählens eines Silizium-Einkristallsubstrats, das aus demselben Silizium-Einkristallblock hergestellt wurde wie der Silizium-Einkristallblock, aus dem das bei der Beurteilung als akzeptabel beurteilte Silizium-Einkristallsubstrat hergestellt wurde, als das Silizium-Einkristallsubstrat zum Steuern der Ladungsträger-Rekombinationslebensdauer.

2. Verfahren zum Auswählen eines Silizium-Einkristallsubstrats nach Anspruch 1, wobei in dem Teilchenstrahl-Bestrahlungsschritt (S12) ein Elektronenstrahl mit einer Bestrahlungsdosis von 3×10¹⁴ /cm² oder mehr und 9×10¹⁵ /cm² oder weniger bestrahlt wird.

3. Verfahren zum Auswählen eines Silizium-Einkristallsubstrats nach Anspruch 1 oder 2, wobei in dem Teilchenstrahl-Bestrahlungsschritt (S12) ein Elektronenstrahl mit einer Bestrahlungsdosis von 1×10¹⁵ /cm² bestrahlt wird, und
in dem Beurteilungsschritt (S14) eine Abklingzeit, in der die verbleibende Überschuss-Ladungsträgerkonzentration 3% der Überschuss-Ladungsträgerkonzentration zum Zeitpunkt der Injektion wird, aus der Überschuss-Ladungsträgerabklingkurve erhalten wird, und wenn die erhaltene Abklingzeit 2,0 µs oder weniger beträgt, das Silizium-Einkristallsubstrat als akzeptabel beurteilt wird.

## Revendications

1. Procédé de sélection d'un substrat monocristallin en silicium pour réguler la durée de vie de la recombinaison des porteurs, comprenant:
une étape de préparation (S11) consistant à préparer un substrat monocristallin en silicium comme candidat pour le substrat monocristallin en silicium par fabrication à partir d'un lingot monocristallin en silicium cultivé par une méthode de la zone flottante, méthode FZ;
une étape de rayonnement de faisceau de particules (S12) consistant à soumettre le substrat monocristallin de silicium préparé à un faisceau de particules;
une étape de mesure (S13) consistant à injecter des porteurs excédentaires dans le substrat monocristallin de silicium après l'étape de rayonnement de faisceau de particules (S12) et à mesurer une courbe de décroissance d'une concentration de porteurs excédentaires, courbe de décroissance des porteurs excédentaires, en fonction du temps écoulé après l'injection des porteurs excédentaires, dans lequel une méthode de décroissance photoconductrice par micro-ondes est utilisée comme méthode pour mesurer la courbe de décroissance;
une étape d'évaluation (S14) consistant à obtenir, dans la courbe de décroissance des porteurs excédentaires mesurée, un temps de décroissance après lequel une concentration de porteurs excédentaires restante atteint une partie de la fin de la courbe de décroissance, dans lequel la partie finale étant définie comme la région dans laquelle la concentration de porteurs excédentaires restante est égale à 10 % ou moins de la concentration de porteurs excédentaires au moment de l'injection, et à évaluer le substrat monocristallin en silicium comme acceptable lorsqu'une valeur du temps de décroissance est inférieure ou égale à une valeur d'évaluation prédéterminée; et
une étape de sélection (S15) consistant à sélectionner un substrat monocristallin en silicium fabriqué à partir du même lingot monocristallin en silicium que le lingot monocristallin en silicium à partir duquel le substrat monocristallin en silicium évalué acceptable a été fabriqué en tant que substrat monocristallin en silicium pour réguler la durée de vie de la recombinaison des porteurs.

2. Procédé de sélection d'un substrat monocristallin en silicium selon la revendication 1, dans lequel à l'étape de rayonnement de faisceau de particules (S12), un faisceau d'électrons est émis à une dose de rayonnement de 3×10¹⁴/cm² ou plus et de 9×10¹⁵/cm² ou moins.

3. Procédé de sélection d'un substrat monocristallin en silicium selon la revendication 1 ou 2, dans lequel à l'étape de rayonnement de faisceau de particules (S12), un faisceau d'électrons est émis à une dose de rayonnement de 1×10¹⁵/cm², et
à l'étape d'évaluation (S14), un temps de décroissance au cours duquel la concentration de porteurs excédentaires restante devient 3 % de la concentration de porteurs excédentaires au moment de l'injection est obtenu à partir de la courbe de décroissance des porteurs excédentaires, et lorsque le temps de décroissance obtenu est inférieur ou égal à 2,0 µs, le substrat monocristallin en silicium est évalué comme acceptable.
